# NEUE EUROPÄISCHE PATENTSCHRIFT

(11) **EP 3 154 233 B2**
(45) Veröffentlichungstag und Bekanntmachung des Hinweises auf die Entscheidung über den Einspruch: **17.03.2021**
(45) Hinweis auf die Patenterteilung: 13.09.2017
(21) Anmeldenummer: 16201301.5
(22) Anmeldetag: 09.05.2014
(51) Int. Cl.: H04L 27/06, H04B 17/21

(54) **MESSGERÄT UND MESSVERFAHREN ZUR DETEKTION VON SIMULTANEN DOPPELAUSSENDUNGEN**
MEASUREMENT DEVICE AND METHOD FOR DETECTION OF SIMULTANEOUS DUPLICATE TRANSMISSION
APPAREIL DE MESURE ET PROCÉDÉ DE MESURE DESTINÉS À LA DÉTECTION DE DOUBLES ÉMISSIONS SIMULTANÉES

(30) Priorität: 25.06.2013 DE 102013212067
(43) Veröffentlichungstag der Anmeldung: 12.04.2017
(62) Teilanmeldung aus: 14724398.4
(73) Patentinhaber: Rohde & Schwarz GmbH & Co. KG, 81671 München (DE)
(72) Erfinder: Detert, Thorben, 80634 München (DE)
(74) Vertreter: Lohr, Jöstingmeier & Partner

(56) Entgegenhaltungen:
- EP-A1- 1 160 969
- EP-A1- 1 160 978
- EP-A2- 0 410 663
- DE-A1-102007 037 105
- DE-A1-102011 080 999
- IVAN KADAR: "An Analysis of Helicopter Rotor Modulation Interference", IEEE TRANSACTIONS ON AEROSPACE AND ELECTRONIC SYSTEMS, Bd. AES-10, Nr. 3, 1. Mai 1973 (1973-05-01), Seiten 434-441, XP011167314, NJ, US ISSN: 0018-9251

## Beschreibung

Die Erfindung betrifft ein Messgerät und ein Messverfahren zur Detektion einer gleichzeitigen Anwesenheit zumindest eines ersten Signals und eines zweiten Signals in einem Messsignal.

Im Flugfunk sind amplitudenmodulierte Signale nach wie vor üblich. Ein großes Problem beim Einsatz solcher Signale ist, dass bei einer zufälligen gleichzeitigen Aussendung von Signalen durch z.B. zwei Flugzeuge, das beim Empfänger ankommende schwächere Signal unentdeckt bleibt. Dies kann zu sicherheitsrelevanten Fehlern führen.

Zur Detektion solcher Doppelaussendungen ist ein Verfahren bekannt, bei welchem ein Empfangssignal nichtlinear verzerrt wird und anschließend in den Frequenzbereich übertragen wird. Symmetrische Spektralkomponenten in dem verzerrten Spektrum werden daraufhin ermittelt und entfernt. Anhand noch verbleibender Signalkomponenten wird anschließend auf die Anwesenheit eines gleichzeitig ausgesendeten zweiten Signals geschlossen. So zeigt die Deutsche Offenlegungsschrift DE 10 2011 080 999 A1 ein oben beschriebenes Verfahren mit nichtlinearer Verzerrung. Dieses Verfahren ist jedoch nachteilig, da es auf Grund der nichtlinearen Verzerrung einen hohen Rechenaufwand erfordert. Darüber hinaus ist es im Einsatz mit CLIMAX-Betrieb problematisch. Es ist nicht in der Lage zwischen mehreren Sendern im Gleichwellenbetrieb des CLIMAX-Systems und einer tatsächlichen erkennenswürdigen Doppelaussendung zu unterscheiden.

Ein weiteres Verfahren ist aus der Patentanmeldung DE 10 2007 037105 A1 bekannt. Der Erfindung liegt die Aufgabe zu Grunde, ein einfaches und zuverlässiges Messgerät und Messverfahren zu schaffen, welche in der Lage sind, Doppelaussendungen zuverlässig zu erkennen.

Die Aufgabe wird erfindungsgemäß für das Messgerät durch die Merkmale des unabhängigen Anspruchs 1 und für das Verfahren durch die Merkmale des unabhängigen Anspruchs 3 gelöst. Vorteilhafte Weiterbildungen sind Gegenstand der hierauf rückbezogenen Unteransprüche. Das efindungsgemäße Messgerät dient der Detektion einer gleichzeitigen Anwesenheit zumindest eines ersten Signals und eines zweiten Signals in einem Messsignal, bevorzugt einem Empfangssignal eines Funkgeräts im Flugfunk. Das Messgerät beinhaltet eine Empfangseinrichtung zum Empfang des Messsignals als digitales Messsignal und eine Verarbeitungseinrichtung. Die Verarbeitungseinrichtung weist dabei eine Transformationseinrichtung zur Transformation des digitalen Messsignals in ein Messsignal im Frequenzbereich auf. Die Verarbeitungseinrichtung beinhaltet weiterhin eine Subtraktionseinrichtung zur Subtraktion eines ersten Seitenbands des Messsignals im Frequenzbereich von einem zweiten Seitenband des Messsignals im Frequenzbereich. Es handelt sich dabei bei beiden Seitenbändern um dieselbe Signal-Komponente - um den stärksten Träger. Dabei erzeugt die Subtraktionseinrichtung ein Restsignal. Anhand des Restsignals kann so sehr einfach auf die Anwesenheit einer Doppelaussendung geschlossen werden.

Bevorzugt verarbeitet lediglich die Empfangseinrichtung das Messsignal vor einer Digitalisierung durch die Empfangseinrichtung. Die Empfangseinrichtung verarbeitet das Messsignal dann lediglich mittels linearer Operationen, bevor sie das Messsignal zu dem digitalen Messsignal digitalisiert. Da keine nichtlinearen Operationen notwendig sind, kann eine sehr Rechenressourcen-schonende Verarbeitung gewährleistet werden.

Das erste Signal und das zweite Signal sind bevorzugt amplitudenmodulierte Signale mit jeweils einem Träger. So kann das im Flugfunk vorherrschende Übertragungsverfahren eingesetzt werden.

Bevorzugterweise ist die Subtraktionseinrichtung ausgebildet, um einen stärksten in dem Messsignal vorhandenen Träger zu detektieren, wobei die Seitenbänder des Messsignals durch den stärksten in dem Messsignal vorhandenen Träger getrennt sind. So kann eine zuverlässige Unterscheidung der zu subtrahierenden Seitenbänder gewährleistet werden.

Die Subtraktionseinrichtung ist bevorzugt ausgebildet, um eines der Seitenbänder des Messsignals im Frequenzbereich an einer Position eines stärksten in dem Messsignal vorhandenen Trägers vor der Subtraktion zu spiegeln. So wird eine zuverlässige Funktion des Messgeräts für beliebige Sendesignale erreicht.

Vorteilhafterweise beinhaltet die Verarbeitungseinrichtung eine Detektionseinrichtung zur Detektion der Anwesenheit des zweiten Signals in dem Messsignal basierend auf verbleibenden Signalkomponenten des Restsignals. So kann eine für den Nutzer des Messgeräts sehr einfache automatische Auswertung erreicht werden.

Die Detektionseinrichtung ist bevorzugt ausgebildet, um die Anwesenheit des zweiten Signals in dem Messsignal mittels eines Schwellwertvergleichs verbleibender Signalkomponenten oder mittels eines Schwellwertvergleichs eines von den verbleibenden Signalkomponenten abgeleiteten Signals in dem Restsignal zu bestimmen. D.h. es wird ein Vergleich des abgeleiteten Nutz-Signals gegen das Rauschen durchgeführt. So kann eine sehr einfache Detektion sichergestellt werden.

Die Detektionseinrichtung ist bevorzugt ausgebildet, um die Anwesenheit des zweiten Signals in dem Messsignal mittels eines Schwellwertvergleichs summierter Leistungen verbleibender Signalkomponenten in dem Restsignal zu bestimmen. So kann die Anwesenheit des zweiten Signals mit gesteigerter Genauigkeit detektiert werden.

Die Detektionseinrichtung ist bevorzugt ausgebildet, um Rotormodulationen des ersten Signals und/oder des zweiten Signals zu detektieren, und detektierte Rotormodulationen des ersten Signals und/oder des zweiten Signals aus dem ersten Signal bzw. dem zweiten Signal zu entfernen. Alternativ ist sie ausgebildet, um detektierte Rotormodulationen des ersten Signals und/oder des zweiten Signals bei der Detektion der Anwesenheit des zweiten Signals in dem Messsignal außer Acht zu lassen. So können durch Rotormodulationen verursachte Fehler bei der Detektion einer Doppelaussendung vermieden werden. Das erfindungsgemäße Messverfahren dient der Detektion einer gleichzeitigen Anwesenheit zumindest eines ersten Signals und eines zweiten Signals in einem Messsignal. Dabei wird das Messsignal als digitales Messsignal empfangen. Anschließend wird das digitale Messsignal in ein Messsignal im Frequenzbereich transformiert. Darauf folgt eine Subtraktion eines ersten Seitenbands des Messsignals im Frequenzbereich von einem zweiten Seitenband des Messsignals im Frequenzbereich, wobei dabei ein Restsignal erzeugt wird. Anhand des Restsignals kann so sehr einfach auf die Anwesenheit einer Doppelaussendung geschlossen werden.

Bevorzugt können das erfindungsgemäße Messgerät und das erfindungsgemäße Messverfahren Doppelaussendungen bei einem Pegelunterschied der beiden Signale von 0 bis 20dB, besonders bevorzugt von 0 bis 40dB erkennen. So ist auch bei einem sehr starken und einem sehr schwachen Signal eine zuverlässige Erkennung einer Doppelaussendung möglich.

Besonders bevorzugt sind das Messgerät und das Messverfahren geeignet, um tatsächliche Doppelaussendungen unterschiedlicher Teilnehmer von vermeintlichen Doppelaussendungen im CLIMAX-Verfahren zu unterscheiden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: eine schematische Darstellung des der gegenwärtigen Erfindung zu Grunde liegenden Problems;
- Fig. 2a: eine spektrale Darstellung zweier simultan ausgesendeter Signale im Frequenzbereich;
- Fig. 2b: eine spektrale Summendarstellung der simultan ausgesendeten Signale aus Fig. 2a;
- Fig. 3: ein Ausführungsbeispiel des erfindungsgemäßen Messgeräts in einem Blockschaltbild;
- Fig. 4: eine Detailansicht des Ausführungsbeispiels des erfindungsgemäßen Messgeräts in einem Blockschaltbild;
- Fig. 5: eine spektrale Darstellung eines von dem Ausführungsbeispiel des erfindungsgemäßen Messgerät genutztem Signals, und
- Fig. 6: ein Ausführungsbeispiel des erfindungsgemäßen Messverfahrens in einem Flussdiagramm.

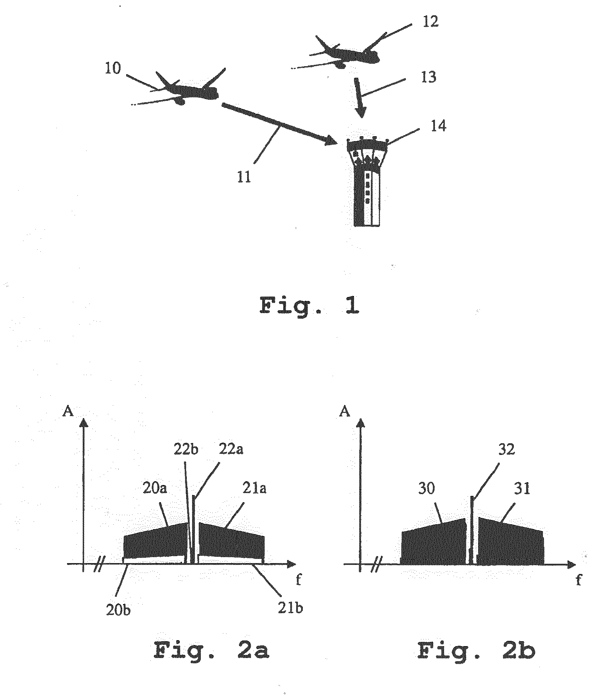

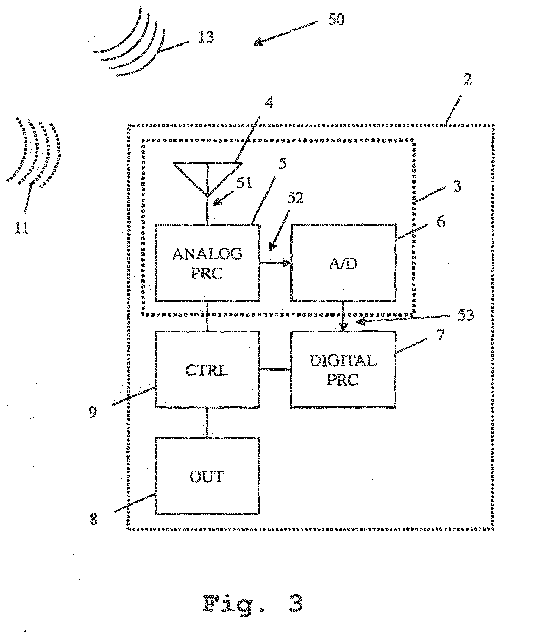

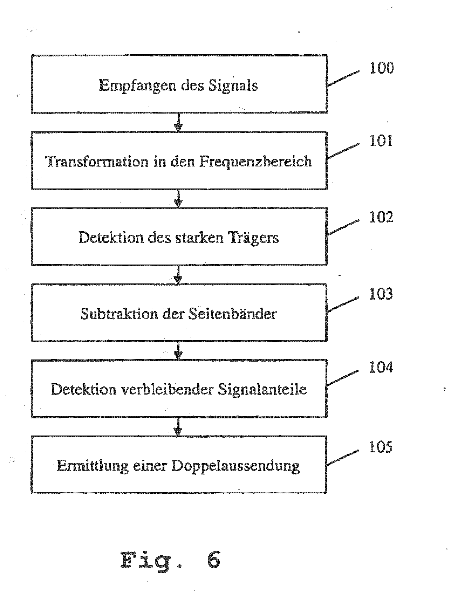

Zunächst wird anhand der Fig. 1 - 2b das der gegenwärtigen Erfindung zu Grunde liegende Problem erläutert.
Anschließend wird anhand von Fig. 3 - 4 ein Ausführungsbeispiel des erfindungsgemäßen Messgeräts und seine Funktion im Detail erklärt. Abschließend wird anhand von Fig. 6 auf die Funktionsweise eines Ausführungsbeispiels des erfindungsgemäßen Verfahrens eingegangen. Identische Elemente wurden in ähnlichen Abbildungen zum Teil nicht wiederholt dargestellt und beschrieben.

In Fig. 1 ist das der Erfindung zu Grunde liegende Problem schematisch dargestellt. Ein erstes Flugzeug 10 sendet ein erstes Signal 11 an einen Empfänger 14. Gleichzeitig sendet ein zweites Flugzeug 12 ein zweites Signal 13 an den Empfänger 14. Auf Grund der deutlich geringeren Entfernung des zweiten Flugzeugs 12 zum Empfänger 14 kommt das zweite Signal 13 mit einem deutlich höheren Pegel bei dem Empfänger 14 an als das erste Signal 11. Auf Grund der Amplitudenmodulation und des Einsatzes der nominell gleichen Sendefrequenz verschwindet das erste Signal 11 im stärkeren zweiten Signal 13 und kann ohne weitere Maßnahmen von dem Empfänger 14 nicht detektiert werden. Eine von dem Flugzeug 10 an den Empfänger 14 gesendete Nachricht kommt somit nicht an. Selbstverständlich können das erfindungsgemäße Messgerät und das erfindungsgemäße Messverfahren auch bei abweichender Konstellation der Teilnehmer eingesetzt werden. So ist z.B. eine Doppelaussendung eines Flugzeugs und einer Bodenstation bei einem Empfang durch ein Flugzeug oder eine Bodenstation denkbar. Allgemein ausgedrückt, kann jeder der dargestellten Teilnehmer durch ein Flugzeug oder eine Bodenstation ersetzt werden.

In Fig. 2a ist die in Fig. 1 dargestellte Situation im Frequenzbereich dargestellt. Dem ersten Signal 11 aus Fig. 1 entsprechen hier das linke Seitenband 20b, das rechte Seitenband 21b und der Träger 22b. Dem zweiten Signal 13 aus Fig. 1 entsprechen hier das linke Seitenband 20a, das rechte Seitenband 21a und der Träger 22a. Deutlich erkennbar ist hier, dass die dem ersten Signal 11 entsprechenden Komponenten einen deutlich geringeren Pegel aufweisen, als die dem zweiten Signal 13 entsprechenden Komponenten. D.h. die Komponenten des ersten Signals 11 in dem zweiten Signal 13 verschwinden.

In Fig. 2b ist ein beim Empfänger 14 aus Fig. 1 ankommendes Gesamtsignal spektral dargestellt. Auf Grund geringfügiger Frequenzunterschiede der beiden Signale ergibt sich eine geringfügige Asymmetrie des Summensignals, welches in Fig. 2b dargestellt ist. Um einen erkennbaren zentralen Träger 32 sind ein linkes Seitenband 30 und ein rechtes Seitenband 31 erkennbar. Kaum zu erkennen sind hier die Beiträge des ersten Signals 11 aus Fig. 1. Lediglich im linken Fußbereich des linken Seitenbands 30 und des rechten Seitenbands 31 und am Fußpunkt des Trägers 32 sind kleine Änderungen gegenüber einem einzelnen Signal erkennbar. Aus diesen Bereichen direkt auf eine Doppelaussendung zu schließen ist jedoch nicht möglich. Selbstverständlich kann das gesamte empfangene Signal auch nur ein Nutzsignal, z.B. das erste Signal 11 oder das zweite Signal 13 und Rauschen enthalten. Dieser Fall ist somit im Rahmen der Doppelaussendungsdetektion von dem oben dargestellten Fall zu unterscheiden.

Fig. 3 zeigt ein Ausführungsbeispiel des erfindungsgemäßen Messgeräts in einem Blockschaltbild. Das erste Signal 11 aus Fig. 1 und das zweite Signal 13 aus Fig. 1 bilden gemeinsam ein Messsignal 50. Das Messgerät 2 beinhaltet eine Empfangseinrichtung 3, eine digitale Verarbeitungseinrichtung 7, eine Ausgabeeinrichtung 8 und eine Steuereinrichtung 9. Die Empfangseinrichtung 3 beinhaltet weiterhin eine Antenne 4, eine Analogverarbeitungseinrichtung 5 und einen Analog-Digital-Wandler 6. Die Antenne 4 ist dabei mit der Analogverarbeitungseinrichtung 5 verbunden, welche wiederum mit dem Analog-Digital-Wandler 6 verbunden ist. Diese wiederum ist mit der digitalen Verarbeitungseinrichtung 7 verbunden. Die Analogverarbeitungseinrichtung 5, die digitalen Verarbeitungseinrichtung 7 und die Ausgabeeinrichtung 8 sind dabei weiterhin mit einer Steuereinrichtung 9 verbunden. Hier sind lediglich die für die Erfindung relevanten Komponenten des Messgeräts dargestellt. Übliche Empfangstechnik, wie sie in einem Flugfunkgerät eingesetzt wird, ist hier nicht im Detail dargestellt.

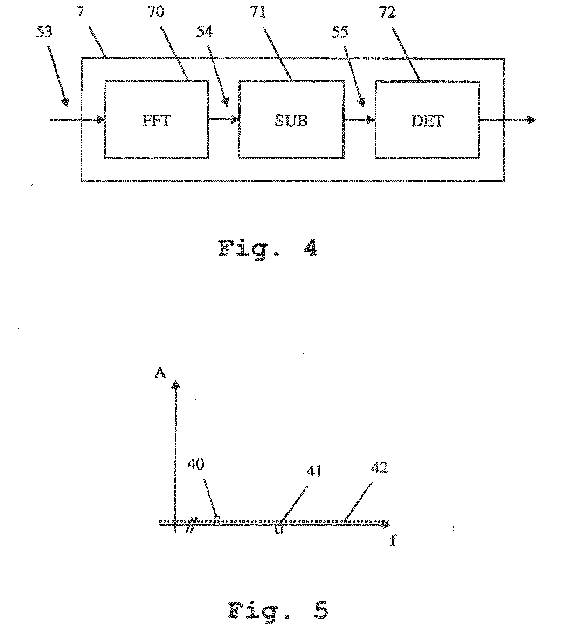

Das Messsignal 50, welches zumindest ein Signal, z.B. von einem Flugzeug beinhaltet - alternativ bei einer Doppelaussendung jedoch ein erstes und ein zweites Signal beinhalten kann -, wird von der Antenne 4 empfangen und als empfangenes Signal 51 an die Analogverarbeitungseinrichtung 5 übertragen. Diese führt analoge Verarbeitungsschritte, wie z.B. eine Filterung und eine Verstärkung durch und gibt ein verarbeitetes Messsignal 52 an den Analog-Digital-Wandler 6 aus. Dieser digitalisiert das Signal und überträgt es als digitales Messsignal 53 an die digitale Verarbeitungseinrichtung 7. Diese führt die Detektion der Doppelaussendung durch und teilt ein Ergebnis der Steuereinrichtung 9 mit. Die Steuereinrichtung 9 steuert im Fall einer Doppelaussendung die Ausgabeeinrichtung 8 an, um die Doppelaussendung, z.B. durch ein akustisches Warnsignal oder ein optisches Warnsignal, anzuzeigen. Die Analogverarbeitungseinrichtung 5, die digitale Verarbeitungseinrichtung 7 und die Ausgabeeinrichtung 8 sind dabei von der Steuereinrichtung 9 gesteuert. Auf die detaillierte Funktion der Digitalverarbeitungseinrichtung 7 wird anhand von Fig. 4 näher eingegangen.

In Fig. 4 ist eine Detailansicht der digitalen Verarbeitungseinrichtung 7 aus Fig. 3 dargestellt. Die digitale Verarbeitungseinrichtung 7 empfängt von dem Analog-Digital-Wandler 6 das digitale Messsignal 53. Die digitale Verarbeitungseinrichtung 7 beinhaltet eine Transformationseinrichtung 70, eine Subtraktionseinrichtung 71 und eine Detektionseinrichtung 72. Die Transformationseinrichtung 70 ist dabei mit dem Analog-Digital-Wandler 6 aus Fig. 3 verbunden. Die Subtraktionseinrichtung 71 ist mit der Transformationseinrichtung 70 und mit der Detektionseinrichtung 72 verbunden. Die Detektionseinrichtung 72 ist mit der Steuereinrichtung 9 aus Fig. 3 verbunden. Das digitale Messsignal wird der Transformationseinrichtung 70 zugeführt und von dieser in ein Messsignal im Frequenzbereich 54 transformiert. Hierzu wird beispielsweise eine Fast Fourier Transformation eingesetzt. Das Messsignal im Frequenzbereich 54 entspricht dabei dem in Fig. 2b dargestellten Gesamtsignal. Das Messsignal im Frequenzbereich 54 wird anschließend der Subtraktionseinrichtung 71 zugeführt, welche ein erstes Seitenband des Gesamtsignals von einem zweiten Seitenband des Gesamtsignals subtrahiert.

Da die beiden Seitenbänder eines amplitudenmodulierten Signals symmetrisch gegenüber dem Träger sind, ergibt sich dabei eine vollständige Auslöschung des Signals, falls lediglich ein Signal Teil des Messsignals war. Diese Asymmetrie kann jedoch in Fig. 2b nicht ohne Weiteres erkannt werden. Insbesondere zeigt Fig. 2b ein ideales Signal ohne Rauschen. In einem realen Signal würden die geringfügigen Asymmetrien des Signals aus Fig. 2b in dem stärkeren Signal verschwinden.

Die Subtraktionseinrichtung 71 ermittelt somit zunächst die genaue Trägerposition im Frequenzbereich des Messsignals im Frequenzbereich 54. Anschließend wird eine Spiegelung eines Seitenbands an dieser ermittelten Trägerposition durchgeführt. Das gespiegelte Seitenband wird von dem nicht gespiegelten Seitenband subtrahiert. Ein im Fall einer Doppelaussendung resultierendes Restsignal 55 ist in Fig. 5 dargestellt.

Ein so erzeugtes Restsignal 55 wird anschließend an die Detektionseinrichtung 72 übertragen, welche aus den im Restsignal 55 vorhandenen Signalkomponenten auf die Anwesenheit oder Abwesenheit einer Doppelaussendung schließt. Hierzu kann beispielsweise ein Schwellwertvergleich herangezogen werden. Alternativ kann das Restsignal 55 zunächst verarbeitet werden, z.B. durch eine Betragsbildung oder eine Leistungsbildung. Das verarbeitete Restsignal kann anschließend mittels eines Schwellwertvergleichs untersucht werden. Wird die Schwelle überschritten, so wird auf die Anwesenheit einer Doppelaussendung geschlossen und dies der Steuereinrichtung 9 aus Fig. 3 mitgeteilt. Auch die Abwesenheit einer Doppelaussendung wird der Steuereinrichtung 9 mitgeteilt.

Bei bisherigen Systemen zur Detektion von Doppelaussendungen werden häufig Rotormodulationen, d.h. Modulationen, welche durch die rotierenden Rotorblätter bei einem propellergetriebenen Flugzeug entstehen, als Doppelaussendungen detektiert. Solche Rotormodulationen erzeugen periodische Fortsetzungen des Sendesignals im Frequenzbereich. Die Periodizität ist dabei durch die Blattanzahl des Rotors und die Drehzahl vorgegeben. Um solche Rotormodulationen auszuschließen und somit nicht als Doppelaussendungen zu detektieren, führt die Detektionseinrichtung 72 zusätzlich eine Rotormodulationskompensation durch. In diesem Fall sucht die Detektionseinrichtung 72 gezielt nach Rotormodulationen, welche anhand der bekannten Periodizität erkannt werden und entfernt diese periodischen Wiederholungen des Signals im Frequenzbereich bevor der Schwellwertvergleich durchgeführt wird.

In Fig. 5 ist das Restsignal 55 aus Fig. 4 im Falle einer Doppelaussendung dargestellt. Das Restsignal 55 beinhaltet hier zwei Signalkomponenten 40, 41, welche den in Fig. 2b schwer erkennbaren Asymmetrien des Gesamtsignals entsprechen. Nachdem nun die symmetrischen Signalkomponenten entfernt wurden, können diese asymmetrischen Signalkomponenten einfach detektiert werden. In Fig. 5 ist weiterhin ein Schwellwert 42 eingezeichnet, anhand dessen beispielsweise die Anwesenheit der Doppelaussendung detektiert wird.

In Fig. 6 ist ein Ausführungsbeispiel des erfindungsgemäßen Verfahrens gezeigt. In einem ersten Schritt 100 wird ein Messsignal empfangen. Dieses Messsignal beinhaltet zumindest ein erstes Signal, optional jedoch ein zweites Signal. In einem zweiten Schritt 101 wird das Messsignal in den Frequenzbereich transformiert. In einem dritten Schritt 102 wird ein stärkster Träger innerhalb des empfangenen Signals detektiert. In einem vierten Schritt 103 werden die beiden Seitenbänder, welche durch die beiden spektralen Seiten des detektierten stärksten Trägers definiert sind, voneinander subtrahiert. Dabei wird zunächst eines der Seitenbänder an der Trägerposition gespiegelt. In einem fünften Schritt 104 werden verbleibende Signalanteile nach der Subtraktion detektiert. In einem sechsten Schritt 105 wird eine Doppelaussendung ermittelt. Hinsichtlich der Funktion der einzelnen Schritte wird auf die korrespondierenden Abschnitte zu Fig. 3 und Fig. 4 verwiesen.

Die Erfindung ist nicht auf das dargestellte Ausführungsbeispiel beschränkt. Alle vorstehend beschriebenen Merkmale oder in den Figuren gezeigten Merkmale sind im Rahmen der Erfindung beliebig vorteilhaft miteinander kombinierbar.

## Patentansprüche

1. Messgerät zur Detektion einer gleichzeitigen Anwesenheit zumindest eines ersten Signals (11) und eines zweiten Signals (13) in einem Messsignal (50), mit einer Empfangseinrichtung (3) zum Empfang des Messsignals (50) als digitales Messsignal (53) und einer Verarbeitungseinrichtung (7),
wobei die Verarbeitungseinrichtung (7) eine Transformationseinrichtung (70) zur Transformation des digitalen Messsignals (53) in ein Messsignal im Frequenzbereich (54) aufweist,
**dadurch gekennzeichnet,**
**dass** die Verarbeitungseinrichtung (7) eine Subtraktionseinrichtung (71) zur Subtraktion eines ersten Seitenbands (30) des Messsignals im Frequenzbereich (54) von einem zweiten Seitenband (31) des Messsignals im Frequenzbereich (54) aufweist, wobei die Subtraktionseinrichtung (71) dabei ein Restsignal (55) erzeugt, und
**dass** die Verarbeitungseinrichtung (7) eine Detektionseinrichtung (72) zur Detektion der Anwesenheit des zweiten Signals (13) in dem Messsignal (50) basierend auf verbleibenden Signalkomponenten des Restsignals (55) beinhaltet
**dass** die Empfangseinrichtung (3) das Messsignal (50) lediglich mittels linearer Operationen verarbeitet, bevor sie das Messsignal (50) zu dem digitalen Messsignal (53) digitalisiert, und wobei das erste Signal (11) und das zweite Signal (13) amplitudenmodulierte Signale mit jeweils einem Träger (22a, 22b) sind, und
**dass** die Subtraktionseinrichtung (71) ausgebildet ist, um eines der Seitenbänder (30, 31) des Messsignals im Frequenzbereich (54) vor der Subtraktion an einer Position eines stärksten in dem Messsignal (50) vorhandenen Trägers (32) zu spiegeln, und
**dass** die Subtraktionseinrichtung (71) ausgebildet ist, um einen stärksten in dem Messsignal vorhandenen Träger (32) zu detektieren, wobei die Seitenbänder (30, 31) des Messsignals (50) durch den stärksten in dem Messsignal (50) vorhandenen Träger (32) getrennt sind.

2. Messgerät nach Anspruch 1,
**dadurch gekennzeichnet,**
**dass** die Detektionseinrichtung (72) ausgebildet ist, um die Anwesenheit des zweiten Signals (13) in dem Messsignal (50) mittels eines Schwellwertvergleichs verbleibender Signalkomponenten in dem Restsignal (55) oder mittels eines Schwellwertvergleichs summierter Leistungen verbleibender Signalkomponenten in dem Restsignal (55) zu bestimmen.

3. Messverfahren zur Detektion einer gleichzeitigen Anwesenheit zumindest eines ersten Signals (11) und eines zweiten Signals (13) in einem Messsignal (50), mit den folgenden Schritten:
- Empfang des Messsignals (50) als digitales Messsignal (53),
- Transformation des digitalen Messsignals (53) in ein Messsignal im Frequenzbereich (54),
**dadurch gekennzeichnet,**
**dass** das Verfahren zusätzlich folgenden Schritt aufweist:
- Subtrahieren eines ersten Seitenbands (30) des Messsignals im Frequenzbereich (54) von einem zweiten Seitenband des Messsignals im Frequenzbereich (54), wobei dabei ein Restsignal (55) erzeugt wird, das zur Detektion der Anwesenheit des zweiten Signals im Messsignal basierend auf verbleibenden Signalkomponenten des Restsignals verwendet wird, und
**dass** das Messsignal (50) lediglich mittels linearer Operationen verarbeitet wird, bevor das Messsignal (50) zu dem digitalen Messsignal (53) digitalisiert wird, wobei das erste Signal (11) und das zweite Signal (13) amplitudenmodulierte Signale mit jeweils einem Träger (22a, 22b) sind, und
**dass** eines der Seitenbänder (30, 31) des Messsignals im Frequenzbereich (54) vor der Subtraktion an einer Position eines stärksten in dem Messsignal (50) vorhandenen Trägers (32) gespiegelt wird, und
**dass** ein stärkster in dem Messsignal vorhandener Träger (32) detektiert wird, wobei die Seitenbänder (30, 31) des Messsignals (50) durch den stärksten in dem Messsignal (50) vorhandenen Träger (32) getrennt sind

4. Messverfahren nach Anspruch 3,
**dadurch gekennzeichnet,**
**dass** die Anwesenheit des zweiten Signals (13) in dem Messsignal (50) mittels eines Schwellwertvergleichs verbleibender Signalkomponenten in dem Restsignal (55) oder mittels eines Schwellwertvergleichs summierter Leistungen verbleibender Signalkomponenten in dem Restsignal (55) bestimmt werden.

5. Computerprogramm mit Programmcodemitteln, um alle Schritte eines Verfahrens nach einem der Ansprüche 3 bis 4 durchzuführen, wenn das Programm auf einem Computer oder einem digitalen Signalprozessor ausgeführt wird.

6. Computerprogrammprodukt mit einem computerlesbarem Medium, auf welchem Programmcodemittel gespeichert sind, um alle Schritte eines Verfahrens nach einem der Ansprüche 4 bis 4 auszuführen, wenn das Programm auf einem Computer oder einem digitalen Signalprozessor ausgeführt wird.

## Claims

1. Measuring apparatus for detection of a simultaneous presence of at least a first signal (11) and a second signal (13) in a measurement signal (50), with a receiving means (3) for reception of the measurement signal (50) in the form of a digital measurement signal (53) and a processing means (7),
wherein the processing device (7) has a transformation means (70) for transformation of the digital measurement signal (53) into a measurement signal in the frequency domain (54),
**characterized in**
**that** the processing means (7) comprises a subtraction means (71) for subtraction of a first side band (30) of the measurement signal in the frequency domain (54) from a second side band (31) of the measurement signal in the frequency domain (54), wherein in the process the subtraction device (71) generates a residual signal (55), and
**in that** the processing means (7) comprises a detecting means (72) for detection of the presence of the second signal (13) in the measurement signal (50) based on remaining signal components of the residual signal (55)
**in that** the receiving means (3) processes the measurement signal (50) solely by means of linear operations before it digitizes the measurement signal (50) to form the digital measurement signal (53), and wherein the first signal (11) and the second signal (13) are amplitude-modulated signals each with a carrier (22a, 22b), and
**in that** the subtraction means (71) is configured in order to reflect one of the side bands (30, 31) of the measurement signal in the frequency domain (54) before the subtraction in a position of a strongest carrier (32) present in the measurement signal (50), and
**that** the subtraction means (71) is configured in order to detect the strongest carrier (32) present in the measurement signal, the side bands (30, 31) of the measurement signal (50) being separated by the strongest carrier (32) present in the measurement signal (50).

2. Measurement apparatus according to claim 1,
**characterized in**
**that** the detecting means (72) is configured in order to determine the presence of the second signal (13) in the measurement signal (50) by means of a threshold value comparison of remaining signal components in the residual signal (55) or by means of a threshold value comparison of summed powers of remaining signal components in the residual signal (55).

3. Measurement method for detection of a simultaneous presence of at least a first signal (11) and a second signal (13) in a measurement signal (50), with the following steps:
- reception of the measurement signal (50) in the form of a digital measurement signal (53),
- transformation of the digital measurement signal (53) into a measurement signal in the frequency domain (54),
**characterized in**
**that** the method additionally comprises the following step:
- subtraction of a first side band (30) of the measurement signal in the frequency domain (54) from a second side band of the measurement signal in the frequency domain (54), wherein in the process a residual signal (55) is generated which is used for detection of the presence of the second signal in the measurement signal based on remaining signal components of the residual signal, and
**in that** the measurement signal (50) is processed solely by means of linear operations before the measurement signal (50) is digitized to form the digital measurement signal (53), wherein the first signal (11) and the second signal (13) are amplitude-modulated signals with one carrier (22a, 22b) each, and
**in that** one of the side bands (30, 31) of the measurement signal in the frequency domain (54) is reflected before the subtraction in a position of a strongest carrier (32) present in the measurement signal (50), and
**that** a strongest carrier (32) present in the measurement signal is detected, the side bands (30, 31) of the measurement signal (50) being separated by the strongest carrier (32) present in the measurement signal (50)

4. Measurement method according to claim 3,
**characterized in**
**that** the presence of a second signal (13) in the measurement signal (50) is determined by means of a threshold value comparison of remaining signal components in the residual signal (55) or by means of a threshold value comparison of summed powers of remaining signal components in the residual signal (55).

5. Computer program with program code means in order to implement all the steps of a method according to one of claims 3 to 4 when the program is executed on a computer or a digital signal processor.

6. Computer program product with a computer readable medium on which program code means are stored in order to execute all the steps of a method according to one of claims 3 to 4 when the program is executed on a computer or a digital signal processor.

## Revendications

1. Appareil de mesure pour la détection de la présence simultanée d'au moins un premier signal (11) et d'un deuxième signal (13) dans un signal de mesure (50), comprenant un dispositif de réception (3) pour la réception du signal de mesure (50) sous forme de signal de mesure numérique (53), et un dispositif de traitement de données (7),
le dispositif de traitement de données (7) comportant un dispositif de transformation (70) pour la transformation du signal de mesure numérique (53) en un signal de mesure dans la plage de fréquences (54),
**caractérisé en ce que** le dispositif de traitement de données (7) comporte un dispositif de soustraction (71) pour soustraire une première bande latérale (30) du signal de mesure dans la plage de fréquences (54) d'une deuxième bande latérale (31) du signal de mesure dans la plage de fréquences (54), le dispositif de soustraction (71) produisant à cette occasion un signal restant (55), et
**en ce que** le dispositif de traitement des données (7) comprend un dispositif de détection (72) destiné à détecter la présence du deuxième signal (13) dans le signal de mesure (50) sur la base des composantes de signal résiduelles du signal restant (55),
**en ce que** le dispositif de réception (3) traite le signal de mesure (50) uniquement par des opérations linéaires, avant de numériser le signal de mesure (50) pour l'obtention du signal de mesure numérique (53), le premier signal (11) et le deuxième signal (13) étant des signaux modulés en amplitude avec chacun une porteuse (22a, 22b) et
**en ce que** le dispositif de soustraction (71) est conçu pour symétriser par réflexion l'une des bandes latérales (30, 31) du signal de mesure dans la plage de fréquences (54) avant la soustraction, dans une position d'une porteuse (32) la plus intense présente dans le signal de mesure (50), et
**en ce que** le dispositif de soustraction (71) est conçu pour détecter une porteuse (32) la plus intense présente dans le signal de mesure, les bandes latérales (30, 31) du signal de mesure (50) étant séparées par la porteuse (32) la plus intense dans le signal de mesure (50).

2. Appareil de mesure selon la revendication 1, **caractérisé en ce que** le dispositif de détection (72) est conçu pour déterminer la présence du deuxième signal (13) dans le signal de mesure (50) au moyen d'une comparaison à valeur de seuil de composantes de signal résiduelles dans le signal restant (55) ou au moyen d'une comparaison à valeur de seuil de puissances additionnées de composantes de signal résiduelles dans le signal restant (55).

3. Procédé de mesure pour la détection de la présence simultanée d'au moins un premier signal (11) et d'un deuxième signal (13) dans un signal de mesure (50), comprenant les étapes suivantes :
- réception du signal de mesure (50) sous forme de signal de mesure numérique (53),
- transformation du signal de mesure numérique (53) en un signal de mesure dans la plage de fréquences (54),
**caractérisé en ce que** le procédé comprend en supplément l'étape suivante :
- soustraction d'une première bande latérale (30) du signal de mesure dans la plage de fréquences (54) d'une deuxième bande latérale du signal de mesure dans la plage de fréquences (54), en produisant à cette occasion un signal restant (55) qui est utilisé pour la détection de la présence du deuxième signal dans le signal de mesure sur la base de composantes de signal résiduelles du signal restant, et
**en ce que** l'on traite le signal de mesure (50) uniquement par des opérations linéaires avant de numériser le signal de mesure (50) pour l'obtention du signal de mesure numérisé (53), le premier signal (11) et le deuxième signal (13) étant des signaux modulés en amplitude avec chacun une porteuse (22a, 22b), et
**en ce qu'**avant la soustraction, l'une des bandes latérales (30, 31) du signal de mesure est symétrisée par réflexion dans la plage de fréquences (54) dans une position d'une porteuse (32) la plus intense présente dans le signal de mesure (50), et
**en ce que** l'on détecte une porteuse (32) la plus intense présente dans le signal de mesure, les bandes latérales (30, 31) du signal de mesure (50) étant séparées par la porteuse (32) la plus intense dans le signal de mesure (50).

4. Procédé de mesure selon la revendication 3, **caractérisé en ce que** l'on détermine la présence du deuxième signal (13) dans le signal de mesure (50) au moyen d'une comparaison à valeur de seuil de composantes de signal résiduelles dans le signal restant (55) ou bien au moyen d'une comparaison à valeur de seuil de puissances additionnées de composantes de signal résiduelles dans le signal restant (55).

5. Programme d'ordinateur comprenant des moyens de codes de programme pour exécuter toutes les étapes d'un procédé selon l'une des revendications 3 à 4 lorsque le programme est exécuté sur un ordinateur ou un processeur de traitement de signal numérique.

6. Produit de programme d'ordinateur comprenant un support lisible par ordinateur, sur lequel sont mémorisés des moyens de codes de programmes en vue d'exécuter toutes les étapes d'un procédé selon l'une des revendications 3 à 4 lorsque le programme est exécuté sur un ordinateur ou un processeur de traitement de signal numérique.
